# EUROPEAN PATENT APPLICATION

(11) **EP 4 539 105 A1**
(43) Date of publication of application: **16.04.2025**
(21) Application number: 23831306.8
(22) Date of filing: 23.06.2023
(51) Int. Cl.: H01L 21/316, C25D 11/32, H01L 21/306

(54) **SILICON CARBIDE SINGLE CRYSTAL SUBSTRATE PROCESSING METHOD, AND SILICON CARBIDE SINGLE CRYSTAL SUBSTRATE PROCESSING SYSTEM**

(30) Priority: 30.06.2022 JP 2022106470
(71) Applicant: TOKYO OHKA KOGYO CO., LTD., Kawasaki-shi, Kanagawa 211 0012 (JP)
(72) Inventor: WADA, Yukihisa, Kawasaki-shi, Kanagawa 211-0012 (JP); GO, Choitsu, Kawasaki-shi, Kanagawa 211-0012 (JP)
(74) Representative: Plasseraud IP
(86) International application number: PCT/JP2023/023362
(87) International publication number: WO 2024/004864

(57) **Abstract**

Provided are: a silicon carbide single crystal substrate processing method by which the thickening of a desired surface of a SiC single crystal substrate can be achieved in a short time under mild conditions such as room temperature; and a silicon carbide single crystal substrate processing system applicable to said processing method. The silicon carbide single crystal substrate processing method comprises a step (A) for performing anodic oxidation, in which a voltage is applied using the silicon carbide single crystal substrate as an anode while at least one main surface of the silicon carbide single crystal substrate is brought into contact with an electrolyte solution that does not contain fluorine anions, to thereby form an oxide film on the main surface.

## Description

### TECHNICAL FIELD

The present invention relates to a silicon carbide single crystal substrate treating method and a silicon carbide single crystal substrate treating system.

### BACKGROUND ART

Since SiC (silicon carbide), a semiconductor material, has a wider band gap than Si (silicon), and is widely used as a substrate for devices at present, studies have been conducted to manufacture power devices, high-frequency devices, high-temperature operating devices, and the like by using a silicon carbide single crystal substrate.

In order to manufacture semiconductor elements (transistors and the like), a smooth semiconductor substrate having a desired thickness is required. Such a substrate is manufactured by a process such as polishing or etching. Silicon carbide single crystal substrates for such applications are required to have high treating accuracy in terms of flatness of the substrate, smoothness of the substrate surface, and the like. However, since silicon carbide is generally high in hardness and excellent in corrosion resistance, the processability when such a substrate is manufactured is poor. It is, thus, difficult to obtain a silicon carbide single crystal substrate having high processing accuracy. Therefore, conventionally, a method of oxidizing both surfaces of a silicon carbide single crystal substrate by thermal oxidation in a batch at 800 to 1200°C for 1 to 5 hours, a method of oxidizing a silicon carbide single crystal substrate by O₂ plasma treatment at 100 to 300°C, and the like have been studied.

Because of its chemical stability, silicon carbide single crystal substrates are poorly soluble in ordinary acids, alkali aqueous solutions, and the like. Patent Document 1 proposes a method of treating a silicon carbide single crystal substrate by electrolytic etching using hydrofluoric acid (HF) as an electrolyte solution. Patent Document 2 proposes a method of treating a silicon carbide single crystal substrate by electrochemical etching or photoelectrochemical etching using an etchant containing hydrofluoric acid, nitric acid, and a surfactant. Patent Document 3 proposes a method of treating a silicon carbide single crystal substrate by photoelectrochemical etching while irradiating light of a specific wavelength and a specific intensity using an etchant containing hydrofluoric acid and nitric acid.

### Citation List

### Patent Document

Patent Document 1: Japanese Patent No. 5560774
Patent Document 2: Japanese Unexamined Patent Application, Publication No. 2021-44271
Patent Document 3: Japanese Patent No. 6821948

### DISCLOSURE OF THE INVENTION

### Problems to be Solved by the Invention

However, as a result of study by the present inventors, in a treating method such as electrolytic etching using an etchant containing fluorine anions as described in Patent Documents 1 to 3, etching of a silicon carbide single crystal substrate was not sufficient in some cases. In addition, in a treating method such as electrolytic etching using an etchant containing fluorine anions as described in Patent Documents 1 to 3, it was sometimes difficult to form a flat surface on a desired surface of an etched SiC substrate, and there was room for improvement.

The present invention has been made in view of the above circumstances, and an object of the present invention is to provide a silicon carbide single crystal substrate treating method, the method being capable of controlling film thickness of a desired surface of the silicon carbide single crystal substrate in a short time under mild conditions such as room temperature, and a silicon carbide single crystal substrate treating system applicable to the treating method.

### Means for Solving the Problems

In order to solve the above problems, the present invention adopts the following configuration.
(1) A method for treating a silicon carbide single crystal substrate, including: a step (A) of forming an oxidized film on at least one main surface of the silicon carbide single crystal substrate by anodization using the silicon carbide single crystal substrate as an anode and applying a voltage while bringing the at least one main surface of the silicon carbide single crystal substrate into contact with an electrolyte solution free of a fluorine anion.
(2) The method for treating a silicon carbide single crystal substrate as described in (1), in which the electrolyte solution has a final current density of 0.01 mA/cm² or more, the final current density being a current density, a variation width of which is in a range of ±3 mA/cm² continuously for 60 seconds after the voltage is applied in the step (A).
(3) The method for treating a silicon carbide single crystal substrate as described in (1) or (2), further including a step (B) of removing the oxidized film by any of etching using at least one etchant selected from the group consisting of hydrofluoric acid and a mixture of hydrofluoric acid and ammonium fluoride, dry etching, ashing, or CMP.
(4) The method for treating a silicon carbide single crystal substrate as described in (3), in which the dry etching or the ashing includes etching with a gas containing a halogen atom.
(5) The method for treating a silicon carbide single crystal substrate as described in any one of (1) to (4), in which the electrolyte solution contains at least one selected from the group consisting of orthoperiodic acid, a periodate salt, iodic acid, and an iodate salt.
(6) The method for treating a silicon carbide single crystal substrate as described in any one of (1) to (4), in which the electrolyte solution contains at least one selected from the group consisting of an acid free of a fluorine atom, a peracid free of a fluorine atom, and hydrogen peroxide.
(7) The method for treating a silicon carbide single crystal substrate as described in (6), in which the electrolyte solution is at least one selected from the group consisting of a carboxylic acid free of a fluorine atom, a percarboxylic acid free of a fluorine atom, a sulfonic acid free of a fluorine atom, a phosphonic acid free of a fluorine atom, an inorganic acid free of a fluorine atom, and hydrogen peroxide.
(8) The method for treating a silicon carbide single crystal substrate as described in (7), in which the sulfonic acid free of a fluorine atom contains at least one selected from the group consisting of sulfuric acid and methanesulfonic acid.
(9) The method for treating a silicon carbide single crystal substrate as described in (7), in which the phosphonic acid free of a fluorine atom contains at least one selected from the group consisting of phosphoric acid and polyphosphoric acid.
(10) The method for treating a silicon carbide single crystal substrate as described in any one of (1) to (4), in which the electrolyte solution contains an alkali free of a fluorine atom.
(11) The method for treating a silicon carbide single crystal substrate as described in (10), in which the alkali is at least one selected from the group consisting of a quaternary ammonium hydroxide salt free of a fluorine atom, a tertiary amine free of a fluorine atom, a secondary amine free of a fluorine atom, a primary amine free of a fluorine atom, and ammonia.
(12) The method for treating a silicon carbide single crystal substrate as described in any one of (1) to (4), in which the electrolyte solution contains an ammonium salt free of a fluorine atom.
(13) The method for treating a silicon carbide single crystal substrate as described in any one of (1) to (12), in which the electrolyte solution contains at least one antifoaming agent selected from the group consisting of an organic solvent and a surfactant.
(14) The method for treating a silicon carbide single crystal substrate as described in (13), in which the antifoaming agent contains an alcohol solvent.
(15) The method for treating a silicon carbide single crystal substrate as described in any one of (1) to (14), in which the step (A) is performed at a liquid temperature of the electrolyte solution of 300°C or less.
(16) A silicon carbide single crystal substrate treating system including: an anode that is a silicon carbide single crystal substrate; a cathode opposed to the silicon carbide single crystal substrate; an electrolyte solution interposed between the silicon carbide single crystal substrate and the cathode, being in contact with the anode and the cathode, and being free of a fluorine anion; and a power source device connected between the anode and the cathode and causing an anodization reaction at an interface of at least one main surface of the anode by application of a voltage.
(17) A replenishing liquid for use in replenishing the electrolyte solution for use in the method for treating a silicon carbide single crystal substrate as described in any one of (1) to (15), in which the replenishing liquid has a higher electrolyte concentration than the electrolyte solution.

### Effects of the Invention

According to the present invention, it is possible to provide a silicon carbide single crystal substrate treating method capable of controlling film thickness of a desired surface of the silicon carbide single crystal substrate in a short time under a mild condition such as room temperature, and a silicon carbide single crystal substrate treating system applicable to the treating method.

### BRIEF DESCRIPTION OF THE DRAWINGS

[FIG. 1] FIG. 1 is a schematic diagram showing an example of a silicon carbide single crystal substrate treating system according to the present embodiment.
[FIG. 2A] FIG. 2A is a schematic view of a silicon carbide single crystal substrate treating device used in Examples.
[FIG. 2B] FIG. 2B is a top view of a cell of the silicon carbide single crystal substrate treating device used in Examples.
[FIG. 3] FIG. 3 is an XPS spectrum of Si atoms (silicon atoms) of a SiC substrate subjected to an anodization treatment in Examples.
[FIG. 4] FIG. 4 is an XPS spectrum of C atoms (carbon atoms) of a SiC substrate subjected to an anodization treatment in Example.
[FIG. 5] FIG. 5 is an XPS spectrum of O atoms (oxygen atoms) of a SiC substrate subjected to an anodization treatment in Examples.

### PREFERRED MODE FOR CARRYING OUT THE INVENTION

### <Method for Treating Silicon Carbide Single Crystal Substrate>

The method for treating a silicon carbide single crystal substrate according to the present embodiment includes a step (A) of forming an oxidized film on at least one main surface of the silicon carbide single crystal substrate by anodization using the silicon carbide single crystal substrate as an anode and by applying a voltage while bringing the at least one main surface of the silicon carbide single crystal substrate into contact with an electrolyte solution free of a fluorine anion. In the present embodiment, the "main surface" refers to a main surface of the substrate, and the substrate preferably has a first main surface and a second main surface (for example, a back surface). The present invention also relates to a method for forming an oxidized film including the method for treating a silicon carbide single crystal substrate according to the present embodiment, by including the step (A). The method for treating a silicon carbide single crystal substrate according to the present embodiment may further include a step (B) of etching the oxidized film by any of etching using at least one etchant selected from the group consisting of hydrofluoric acid and a mixture of hydrofluoric acid and ammonium fluoride, dry etching, ashing, or CMP. In the method for treating a silicon carbide single crystal substrate according to the present embodiment, the electrolyte solution does not contain fluorine anions, whereby it is possible to form an oxidized film on the silicon carbide single crystal substrate, the oxidized film allowing satisfactory removal not only by dry etching, ashing, or etching by CMP but also by wet etching using an etchant containing fluorine anions. Hereinafter, each step will be described.

### [Step (A)]

In the step (A), an oxidized film is formed on at least one main surface of a silicon carbide single crystal substrate (hereinafter also referred to as "SiC single crystal substrate") by anodization using the silicon carbide single crystal substrate as an anode and applying a voltage while contacting the silicon carbide single crystal substrate with an electrolyte solution free of a fluorine anion. Specifically, at least one main surface of the SiC single crystal substrate as an anode is brought into contact with an electrolyte solution free of a fluorine anion, and a surface (a surface other than a liquid contact surface) of the SiC single crystal substrate that is not in contact with the electrolyte solution and a cathode are electrically connected to each other with a DC power source device interposed therebetween. Then, a voltage is applied between the single crystal SiC substrate and the cathode by using a DC power source device, whereby an anodization treatment is performed across the entire main surface of the single crystal SiC substrate in an in-plane uniform manner to form an oxidized film on the main surface. The anodization treatment may be performed in an in-plane uniform manner across both the entire main surfaces of the SiC single crystal substrate, one side at a time.

During the anodization treatment, the reactions occurring at the anode and cathode are presumed to be as follows.
Anode: SiC + 4H₂O → SiO₂ + CO₂ + 8H⁺ + 8e⁻
Cathode: 8H⁺ + 8e⁻ → 4H₂

Among the reaction products, carbon dioxide and hydrogen are desorbed as gas from the interface between the silicon carbide single crystal substrate and the electrolyte solution. On the other hand, silicon dioxide is formed on the surface of at least one main surface of the silicon carbide single crystal substrate as the reaction proceeds at the anode, and an oxidized film is formed on the at least one main surface.

The SiC single crystal substrate in the step (A) is not particularly limited, and an industrially available SiC single crystal substrate may be used, or a SiC single crystal substrate having a silicon carbide semiconductor layer epitaxially grown on at least one main surface of the SiC substrate by a known method may be used. In the present embodiment, the SiC single crystal substrate may have a silicon carbide semiconductor layer epitaxially grown only on the first main surface, may have silicon carbide semiconductor layers epitaxially grown on both the first and second main surfaces, or may have no silicon carbide semiconductor layer epitaxially grown on either the first or second main surface.

As the cathode in the step (A), a metal having a smaller ionization tendency than hydrogen can be used. Specifically, a metal such as copper, silver, palladium, platinum, or gold can be used as the cathode. Carbon that is stable in solutions can also be used as a cathode.

In the step (A), the temperature of the electrolyte solution during the anodization is not particularly limited, but is preferably 300°C or less, more preferably 5 to 60°C, and still more preferably 10 to 40°C. When the treatment temperature of the anodization is within the above preferable range, a low boiling point solvent such as an aqueous solvent is easy to use, and the number of types of solvents that can be used is easy to increase. In addition, member selection of the device, safety measures and the like tend to be simple. In addition, it is easy to save power (cost) during manufacturing, and it is easy to shorten cooling time.

In the step (A), the treatment time for anodization is not particularly limited, but is preferably 2 seconds to 30 minutes, more preferably 5 seconds to 20 minutes, and still more preferably 10 seconds to 10 minutes. When the treatment time of the anodization is within the above preferable range, it is easy to form an oxidized film having a desired film thickness on the first main surface with a high yield.

In the step (A), the voltage to be applied for anodization is not particularly limited, but is preferably 1 to 60 V, more preferably 3 to 30 V, and still more preferably 5 to 20 V. When the applied voltage is within the above preferable range, it is easy to form an oxidized film having a desired film thickness on the first main surface.

The electrolyte solution to be used in the step (A) is not particularly limited as long as it is free of a fluorine anion, but from the viewpoint of roughness, a stock solution of the electrolyte solution preferably has a viscosity of 1.0 mPa·s or more and 10 mPa·s or less at 20°C, and an aqueous solution preferably has a conductivity of 0.1 mS/cm or more and 900 mS/cm or less. Examples of the electrolyte solution include aqueous solutions containing any of the following components (E1) to (E4):
component (E1): at least one selected from the group consisting of orthoperiodic acid, a periodate salt, iodic acid, and an iodate salt;
component (E2): at least one selected from the group consisting of an acid free of a fluorine atom, a peracid free of a fluorine atom, and hydrogen peroxide;
component (E3): an alkali free of a fluorine atom; and
component (E4): an ammonium salt free of a fluorine atom.

As the periodate salt of the component (E1), potassium periodate, sodium periodate, barium periodate, lithium periodate, and ammonium periodate are preferable, and sodium periodate is more preferable. As the iodate salt of the component (E1), orthoperiodic acid, sodium iodate, calcium iodate, or silver iodate is preferable. As the component (E1), orthoperiodic acid is preferable from the viewpoint of improving the pattern shape.

As the component (E2), at least one selected from the group consisting of a carboxylic acid free of a fluorine atom, a percarboxylic acid free of a fluorine atom, a sulfonic acid free of a fluorine atom, a phosphonic acid free of a fluorine atom, an inorganic acid free of a fluorine atom, and hydrogen peroxide is preferable. As the carboxylic acid free of a fluorine atom, formic acid, citric acid, malonic acid, acetic acid, benzoic acid, lactic acid, malic acid, propionic acid, butyric acid, and valeric acid are preferable, and citric acid and acetic acid are more preferable. As the percarboxylic acid free of a fluorine atom, peracetic acid, perbenzoic acid, perlactic acid, performic acid, and perpropionic acid are preferable, and peracetic acid is more preferable. As the sulfonic acid free of a fluorine atom, sulfuric acid, methanesulfonic acid, ethanesulfonic acid, benzenesulfonic acid, and p-toluenesulfonic acid are preferable, and an aqueous solution of sulfuric acid or methanesulfonic acid is more preferable. As the phosphonic acid free of a fluorine atom, phosphoric acid, polyphosphoric acid, butylphosphonic acid, propylphosphonic acid, hexylphosphonic acid, and phenylphosphonic acid are preferable, and phosphoric acid and polyphosphoric acid are more preferable. As the inorganic acid free of a fluorine atom, sulfuric acid, phosphoric acid, polyphosphoric acid, nitric acid, nitrous acid, sulfurous acid, phosphorous acid, hydrochloric acid, chloric acid, and perchloric acid are preferable, and sulfuric acid, phosphoric acid, and nitric acid are more preferable.

Among these, as the component (E2), citric acid, acetic acid, peracetic acid, sulfuric acid, phosphoric acid, nitric acid, and hydrogen peroxide are preferable, and sulfuric acid and phosphoric acid are more preferable.

As the component (E3), at least one selected from the group consisting of a quaternary ammonium hydroxide salt free of a fluorine atom, a tertiary amine free of a fluorine atom, a secondary amine free of a fluorine atom, a primary amine free of a fluorine atom, and ammonia is preferable.

Examples of the quaternary ammonium hydroxide salt free of a fluorine atom include tetraethylammonium hydroxide (TEAH), tetramethylammonium hydroxide (TMAH), tetrapropylammonium hydroxide (TPAH), dimethylbis(2-hydroxyethyl)ammonium hydroxide (DMEMAH), tetrabutylammonium hydroxide (TBAH), tetrapropylammonium hydroxide (TPAH), tris(2-hydroxyethyl)methylammonium hydroxide (THEMAH), choline, dimethyldiethylammonium hydroxide, tetraethanolammonium hydroxide, benzyltrimethylammonium hydroxide, benzyltriethylammonium hydroxide, benzyltributylammonium hydroxide are preferable, and tetramethylammonium hydroxide (TMAH) is more preferable.

Examples of the tertiary amine free of a fluorine atom include alkylamines such as trimethylamine, triethylamine, tripropylamine, tributylamine, triisobutylamine, dimethylethylamine, dimethylpropylamine, allyldiethylamine, dimethyl-n-butylamine, and diethylisopropylamine; cycloalkylamines such as tricyclopentylamine and tricyclohexylamine and the like, 4-dimethylaminopyridine, N,N,N',N'-tetramethylethylenediamine, N,N,N',N'-tetraethylethylenediamine, N,N,N',N'-tetramethyl-1,3-diaminopropane, N,N,N',N'-tetramethyl-1,3-diaminobutane, N',N'-tetramethyl-1,4-diaminobutane, N,N,N',N'-tetramethylphenylenediamine, 1,2-dipiperidinoethane, N-methylpiperidine, N-methylpyrrolidine, and N-methylmorpholine are preferable, and tributylamine is more preferable.

Examples of the preferable secondary amine free of a fluorine atom include alkylamines such as dimethylamine, diethylamine, methylethylamine, dipropylamine, diisopropylamine, dibutylamine, diisobutylamine, and butylmethylamine; cycloalkylamines such as N,N-dicyclohexylamine, N-cyclopentylcyclohexanamine; alkoxyamines such as methoxy(methylamine) and N-(2-methoxyethyl)ethylamine; piperidine, 2-pipecolin, 3-pipecolin, 4-pipecolin, 2,6-dimethylpiperidine, 3,5-dimethylpiperidine, pyrrolidine, 2-methylpyrrolidine, 3-methylpyrrolidine, morpholine, 2-methylmorpholine, 3-methylmorpholine, 2-methylpiperazine, 2,3-dimethylpiperazine, 2,5-dimethylpiperazine, N,N'-dimethylethanediamine, N,N'-dimethylpropanediamine, N,N'-diethylethylenediamine, N,N'-diethylpropanediamine, and N,N'-diisopropylethylenediamine and dibutylamine is more preferable.

Examples of preferable primary amine free of a fluorine atom include alkylamines such as methylamine, ethylamine, propylamine, n-butylamine, isopropylamine, and tert-butylamine; cycloalkylamines such as cyclopentylamine, cyclohexylamine, and cyclohexanemethylamine; alkoxyamines such as methoxyethylamine, methoxypropylamine, methoxybutylamine, ethoxypropylamine, and propoxypropylamine, other hydroxylamines, 2-(2-aminoethylamino)ethanol, ethylenediamine, butane 1,4-diamine, 1,3-propanediamine, 1,6-hexanediamine, pentane-1,5-diamine, and monoethanolamine, and n-butylamine and monoethanolamine are more preferable.

Examples of the component (E3) include alkali metal salts such as potassium chloride. Among them, monoethanolamine and TMAH are preferable as the component (E3).

As the component (E4), an ammonium salt of an organic carboxylic acid is preferable, and triammonium citrate, ammonium acetate, triammonium citrate, ammonium acetate, ammonium propionate, ammonium butyrate, and ammonium oxalate are more preferable. Among them, triammonium citrate and ammonium acetate are preferable as the component (E4).

The electrolyte solution may be used alone or in combination of two or more types thereof. Among them, as the electrolyte solution, the component (E1) or a combination of the component (E1) and at least one of the components (E2) to (E4) is preferable, and orthoperiodic acid or a combination of orthoperiodic acid and at least one of the components (E2) to (E4) is more preferable, from the viewpoint of forming an oxidized film having a desired film thickness at a low voltage in a short time.

The concentration of the electrolyte solution is not particularly limited as long as it is an aqueous solution containing any of the components (E1) to (E4), but is preferably 0.0001 to 99.99% by mass, more preferably 0.001 to 90% by mass, and still more preferably 0.002 to 50% by mass. The electrolyte solution (aqueous solution) having a concentration within the above preferable range is easy to form an oxidized film having a desired film thickness on the main surface of the single crystal SiC substrate.

In the present embodiment, the electrolyte solution may contain at least one antifoaming agent selected from the group consisting of an organic solvent and a surfactant.

The organic solvent is preferably an alcohol solvent. Examples of the alcohol solvent include alcohols (monohydric alcohols) such as ethanol, 1-propanol, isopropanol, 1-butanol, 2-butanol, isobutanol, 3-methyl-1-butanol, tert-butyl alcohol, 1-pentanol, 2-pentanol, 1-hexanol, 1-heptanol, 1-octanol, 1-decanol, 2-hexanol, 2-heptanol, 2-octanol, 3-hexanol, 3-heptanol, 3-octanol, 4-octanol, 3-methyl-3-pentanol, cyclopentanol, 2,3-dimethyl-2-butanol, 3,3-dimethyl-2-butanol, 2-methyl-2-pentanol, 2-methyl-3-pentanol, 3-methyl-2-pentanol, 3-methyl-3-pentanol, 4-methyl-2-pentanol, 4-methyl-3-pentanol, cyclohexanol, 5-methyl-2-hexanol, 4-methyl-2-hexanol, 4,5-dimethyl-2-hexanol, 6-methyl-2-heptanol, 7-methyl-2-octanol, 8-methyl-2-nonal, 9-methyl-2-decanol, 3-methoxy-1-butanol, and 3-methoxy-3-methyl-1-butanol; glycol-based solvents such as ethylene glycol, diethylene glycol, propylene glycol and triethylene glycol; polyhydric alcohol solvents such as glycerin; glycol ether solvents containing a hydroxyl group such as ethylene glycol monomethyl ether, propylene glycol monomethyl ether (PGME; also known as 1-methoxy-2-propanol), diethylene glycol monomethyl ether, triethylene glycol monoethyl ether, methoxymethyl butanol, ethylene glycol monoethyl ether, ethylene glycol monopropyl ether, ethylene glycol monobutyl ether, propylene glycol monoethyl ether, propylene glycol monopropyl ether, propylene glycol monobutyl ether, propylene glycol monophenyl ether, and dipropylene glycol dimethyl ether.

Examples of the organic solvent other than the alcohol solvent include propylene glycol monomethyl ether acetate (PEGEMA), acetic acid, ethyl acetate, propyl acetate, isopropyl acetate, butyl acetate, cyclohexanone, DMAC, DMSO, NMP, 2-pyrrolidone, sulfolane, propylene carbonate, acetone, cyclohexanone, and N-methylmorpholine-N-oxide.

Examples of the surfactant include a nonionic surfactant, an anionic surfactant, a cationic surfactant, and an amphoteric surfactant.

Examples of the nonionic surfactant include a polyalkylene oxide alkylphenyl ether-based surfactant, a polyalkylene oxide alkyl ether-based surfactant, a block polymer-based surfactant consisting of polyethylene oxide and polypropylene oxide, a polyoxyalkylene distyrened phenyl ether-based surfactant, a polyalkylene tribenzylphenyl ether-based surfactant, and an acetylene polyalkylene oxide-based surfactant.

Examples of the anionic surfactant include alkyl sulfonic acid, alkyl benzene sulfonic acid, alkyl naphthalene sulfonic acid, alkyl diphenyl ether sulfonic acid, fatty acid amide sulfonic acid, polyoxyethylene alkyl ether carboxylic acid, polyoxyethylene alkyl ether acetic acid, polyoxyethylene alkyl ether propionic acid, alkyl phosphonic acid, and salts of fatty acids. Examples of the "salt" include an ammonium salt, a sodium salt, a potassium salt, and a tetramethylammonium salt.

Examples of the cationic surfactant include alkylpyridium-based surfactants and quaternary ammonium salt-based surfactants.

Examples of the amphoteric surfactant include a betaine surfactant, an amino acid surfactant, an imidazoline surfactant, and an amine oxide surfactant.

The antifoaming agents may be used alone or in combination of two or more types thereof. The content of the antifoaming agent is not particularly limited, but is preferably 0.0001% by mass to 50% by mass, more preferably 0.0002% by mass to 10% by mass, still more preferably 0.002% by mass to 1% by mass, and particularly preferably 0.002% by mass to 0.2% by mass based on the total amount of the electrolyte solution. When the content of the antifoaming agent is within the above preferable range, it is easy to prevent bubble formation on the surface of the SiC single crystal substrate after anodization. Thus, an oxidized film having a desired film thickness can be easily formed in an in-plane uniform manner across the main surface.

In the present embodiment, the electrolyte solution preferably has a final current density of 0.01 mA/cm² or more, more preferably 0.1 mA/cm² or more, and still more preferably 0.3 mA/cm² or more, the final current density being a current density a variation width of which is in a range of ±3 mA/cm² continuously for 60 seconds after the voltage is applied in the step (A). The upper limit of the final current density is not particularly limited, and examples thereof include 20 mA/cm² or less, 15 mA/cm² or less, and 12 mA/cm² or less. When the final current density is within the above preferable range, the formation of an oxidized film more preferentially occurs than the oxidation reaction of the electrolyte solution.

The thickness of the oxidized film formed in the step (A) is not particularly limited, and can be appropriately adjusted according to the purpose. In the present embodiment, for example, an oxidized film having a film thickness of 1 to 2,000 nm can be formed. The thickness of the oxidized film is preferably 10 to 1,800 nm, and more preferably 20 to 1,500 nm.

### [Step (B)]

In the step (B), the oxidized film formed in the step (A) is removed by any one of etching (hereinafter simply referred to as "wet etching") using at least one etchant selected from the group consisting of hydrofluoric acid and a mixture of hydrofluoric acid and ammonium fluoride, dry etching, ashing, and CMP (chemical mechanical polishing). According to the present invention, it is possible to form, on a silicon carbide single crystal substrate, an oxidized film that can be satisfactorily removed not only by dry etching, ashing, or CMP but also by wet etching using an etchant containing a fluorine anion. Treatment conditions for removal are not particularly limited, and known treatment conditions can be employed.

In the case of dry etching or ashing in the step (B), it is preferable to perform the etching treatment with a gas containing halogen atoms from the viewpoint of performing an etching treatment more efficiently. Examples of a gas containing a fluorine atom include CF₄, CHF₃, and SF₆ gas. Examples of a gas containing a chlorine atom include Cl₂ gas and BCl₃ gas.

### [Step (C)]

The method for treating a SiC single crystal substrate according to the present embodiment may or may not include a step (C) of replenishing the electrolyte solution with a replenishing liquid having a higher electrolyte concentration than the electrolyte solution. In the step (C), the electrolyte solution may be replenished with a replenishing liquid having a higher electrolyte concentration than the electrolyte solution. The timing of performing the step (C) is not particularly limited, but when the concentration of the electrolyte solution becomes lower than before the anodization is started, the replenishing liquid may be added to the electrolyte solution. For example, when the electrolyte is an acid, the concentration of hydrogen ions in the replenishing liquid is made higher than that in the electrolyte solution. Further, when the electrolyte is an alkali, the concentration of hydroxide ions in the replenishing liquid is made higher than the concentration in the electrolyte solution. In the present embodiment, it is preferable to add the replenishing liquid to the electrolyte solution when the electrolyte concentration of the electrolyte solution becomes 3% or more lower than that before the start of anodization.

According to the method for treating a SiC single crystal substrate of the present embodiment, it is possible to control film thickness of a desired surface of a SiC single crystal substrate in a short time under mild conditions such as room temperature. In addition, in the method for treating a SiC single crystal substrate according to the present embodiment, a metal-free high-purity solution having high stability that can be used in semiconductors can be used. In addition, an oxidized film having a desired film thickness can be formed in an in-plane uniform manner across the SiC surface, and by etching the oxidized film, it is possible to etch the SiC substrate while maintaining a smooth surface. In addition, the method for treating a SiC single crystal substrate of the present embodiment can eliminate a treatment such as light irradiation during the anodization, it is possible to simplify manufacturing equipment. Therefore, according to the method for treating a SiC single crystal substrate of the present embodiment, it is possible to decrease cost of the entire manufacturing process and increase the yield.

### <Silicon Carbide Single Crystal Substrate Treating System>

A silicon carbide single-crystal substrate treating system according to the present embodiment includes an anode that is a silicon carbide single crystal substrate; a cathode opposed to the silicon carbide single crystal substrate; an electrolyte solution interposed between the silicon carbide single crystal substrate and the cathode, being in contact with the anode and the cathode, and being free of a fluorine anion; and a power source device connected between the anode and the cathode and causing anodization at an interface of at least one main surface of the anode by application of a voltage.

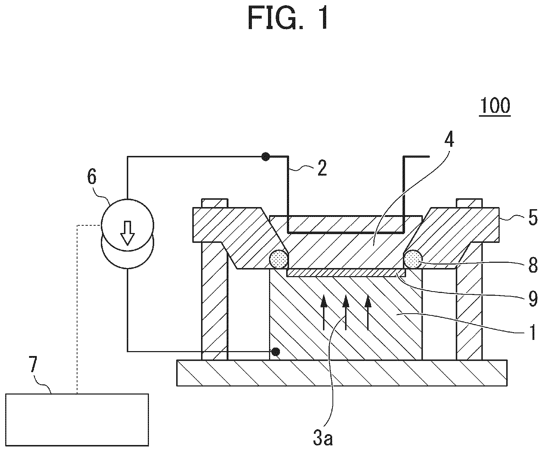

Hereinafter, the silicon carbide single crystal substrate treating system according to the present embodiment will be described with reference to the drawings. FIG. 1 is a schematic diagram showing an example of the silicon carbide single crystal substrate treating system according to the present embodiment. A silicon carbide single crystal substrate treating system 100 includes an electrolysis bath 5 containing an electrolyte solution 4, a power source 6 and a power source controller 7, a cathode (silver, palladium, platinum, gold, carbon, etc.) 2 connected to the power source and a workpiece 1 to be subjected to anodization as an anode (in this case, the SiC single crystal substrate is an anode 1) connected to the power source, and the electrolyte solution 4 interposed between the anode 1 and the cathode 2. In the case of this example, a seal 8 is provided between the electrolysis bath 5 and the anode 1 so that the electrolyte solution 4 does not leak out, but this is for preventing the electrolyte solution 4 from being brought into contact with a surface other than the surface to be treated of the anode 1, and the seal 8 is not always necessary depending on the device configuration. When a current flows through the SiC single crystal substrate (anode 1) and the cathode 2 via the power source controller 7, a current 3a flows toward the substrate surface to cause an anodization reaction, regardless of whether the SiC single crystal substrate is a p-type or n-type substrate. An oxidized film 9 is formed on the SiC single crystal substrate by the anodization reaction.

In the present embodiment, the SiC single crystal substrate (anode 1) is the same as the SiC single crystal substrate in the method for treating a silicon carbide single crystal substrate described above.

In the present embodiment, the electrolyte solution 4 is free of a fluorine anion, and is the same as the electrolyte solution in the above-described method for treating a silicon carbide single crystal substrate. The concentration of the electrolyte solution 4 may be adjusted immediately before the electrolyte solution 4 is brought into contact with the SiC single crystal substrate (anode 1), or the electrolyte solution 4 may be used by adding a chemical solution having a high concentration. Further, even when the electrolyte solution 4 contains impurities such as a substance eluted from the SiC single crystal substrate, with which the electrolyte solution 4 had come into contact, the electrolyte solution 4 may be used as it is, or the impurities may be removed in the circulation process. When the electrolyte solution is used by adding a chemical solution having a high concentration, the replenishment is carried out using a replenishing liquid, which has an electrolyte concentration higher than the electrolyte solution. For example, when the electrolyte is an acid, the concentration of hydrogen ions in the replenishing liquid should be set higher than the concentration in the electrolyte solution. When the electrolyte is an alkali, the concentration of hydroxide ions in the replenishing liquid should be set higher than the concentration in the electrolyte solution.

In the present embodiment, treatment conditions for the anodization are the same as those for the anodization in the above-described method for treating a silicon carbide single crystal substrate.

According to the silicon carbide single crystal substrate treating system of the present embodiment, it is possible to control film thickness of a desired surface of a SiC single crystal substrate in a short time under mild conditions such as room temperature. In addition, in the silicon carbide single crystal substrate treating system according to the present embodiment, a metal-free high-purity solution having high stability that can be used in semiconductors can be used. Further, the silicon carbide single crystal substrate treating system of the present embodiment can eliminate a treatment such as light irradiation during the anodization, it is possible to simplify manufacturing equipment. Therefore, according to the silicon carbide single crystal substrate treating system of the present embodiment, it is possible to decrease cost of the entire manufacturing process and increase the yield. In addition, the SiC single crystal substrate obtained by the silicon carbide single crystal substrate treating system according to the present embodiment can be subjected to a high accuracy processing treatment of the oxidized film by the etching of the step (B) in the above-described silicon carbide single crystal substrate treating method.

The embodiment shown in FIG. 1 is explained by exemplifying the configuration in which the anodization is carried out by horizontally disposing the SiC single crystal substrate (anode 1) on the bottom surface of the electrolysis bath 5, but the silicon carbide single crystal substrate treating system according to the present embodiment is not limited thereto. For example, in a case where a plurality of SiC single crystal substrates are subjected to the anodization treatment at the same time, the anodization treatment may be carried out by providing a substrate holding mechanism, while holding the SiC single crystal substrates so that only a surface to be treated of each SiC single crystal substrate comes into contact with the electrolyte solution 4. In another possible configuration, the anodization treatment may be performed, by disposing the SiC single crystal substrate perpendicular to the bottom surface of the electrolysis bath 5.

### EXAMPLES

Hereinafter, the present invention will be described in more detail with reference to Examples, but will not be limited thereto.

### (Preparation of Electrolyte Solution)

In each Test Example, aqueous electrolyte solutions having compositions shown in Table 1 were prepared.

### [Treatment (1) of SiC Substrate]

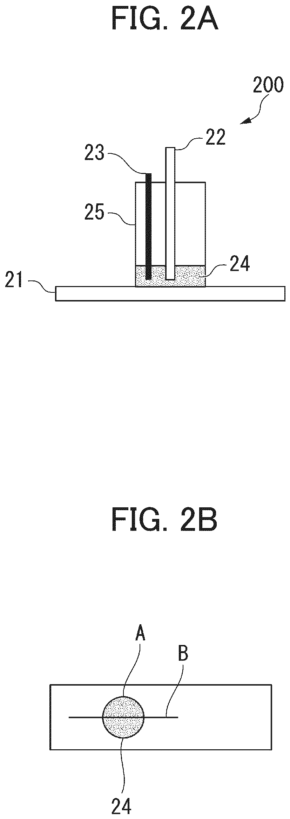

In potentiostat R600+ (manufactured by GAMRY), a SiC wafer (having a silicon carbide semiconductor layer epitaxially grown on the first main surface, manufactured by Showa Denko) was used as an anode (21), an Ag/AgCl electrode was used as a reference electrode (22), and a Pt electrode was used as a negative electrode (23) (FIG. 2A). 1 ml of an electrolyte solution (24) of each Test Example was added to a cell (25) with a radius of 4 mm as shown in FIG. 2B. Then, a voltage shown in Table 1 was applied to a wetted part and/or a voltage application unit (A) at room temperature (23°C) for a treatment time shown in Table 1 using chronocoulometry to perform anodization of the SiC. The thickness (nm) of an oxidized film (SiO₂ film) formed by the voltage application was observed by X-SEM along a portion (B) wetted with the electrolyte. Thereafter, the SiC substrate on which the oxidized film had been formed was immersed in a 5% HF (hydrofluoric acid) solution in a beaker for 10 minutes to remove the oxidized film, and cross-sectional observation was performed by X-SEM. A substrate from which the oxidized film had been removed was evaluated as "O" (good), and a substrate from which the oxidized film had not been removed was evaluated as "X" (poor). The results are shown in Table 1. In each Test Example, the maximum current density (mA/cm²) in the voltage application treatment and the final current density (mA/cm²) were measured, where the final current density is a current density, a variation width of which is in a range of ±3 mA/cm² continuously for 60 seconds after the voltage is applied. The results are shown in Table 1. In Table 1 below, "%" indicates "% by mass". The same applies to Tables 2 and 3 described below.

**[Table 1]**

| Test Example | Electrolyte solution | Voltage application | | SiO₂ film formed by anodization | Oxidized film removal evaluation | Maximum current density (mA/cm² ) | Final current density (mA/cm²) |
|---|---|---|---|---|---|---|---|
| | | Voltage (V) | Treatment time (min) | | | | |
| 1 | 0.001%H₅IO₆ | 7 | 3 | 300 | ○ | 0.562 | 0.188 |
| 2 | 0.01%H₅IO₆ | 7 | 3 | 300 | ○ | 2.68 | 0.64 |
| 3 | 1% H₅IO₆ | 7 | 1 | 100 | ○ | 176 | 1.32 |
| 4 | 1% H₅IO₆ | 7 | 3 | 300 | ○ | 62.36 | 0.88 |
| 5 | 1% H₅IO₆ | 7 | 10 | 300 | ○ | 2.048 | 0.2798 |
| 6 | 1% H₅IO₆ | 4 | 3 | 100 | ○ | 17.2 | 0.4 |
| 7 | 1% H₅IO₆ | 5 | 3 | 300 | ○ | 2.45 | 0.42 |
| 8 | 1% H₅IO₆ | 10 | 3 | 600 | ○ | 80.49 | 0.88 |
| 9 | 20% H₅IO₆ | 7 | 3 | 230 | ○ | 2.048 | 0.86 |
| 10 | 1% HIO₃ | 7 | 3 | 300 | ○ | 2.26 | 0.84 |
| 11 | 1% H₂SO₄ | 7 | 3 | 240 | ○ | 3.266 | 0.832 |
| 12 | 1% H₃PO₄ | 7 | 3 | 240 | ○ | 2.306 | 0.768 |
| 13 | 1% Citric acid | 7 | 3 | 300 | ○ | 1.473 | 0.946 |
| 14 | 1% Acetic acid | 7 | 3 | 300 | ○ | 1.472 | 0.94 |
| 15 | 1% Peracetic acid | 7 | 3 | 200 | ○ | 1.21 | 0.65 |
| 16 | 1% H₂O₂ | 7 | 3 | 210 | ○ | 52.47 | 0.97 |
| 17 | 1% HNO₃ | 7 | 3 | 240 | ○ | 222.53 | 0.44 |
| 18 | 1% NH₄OH | 7 | 3 | 240 | ○ | 18.05 | 0.80 |
| 19 | 1% TMAH | 7 | 3 | 150 | ○ | 165.21 | 0.66 |
| 20 | 1% n-butylamine | 7 | 3 | 200 | ○ | 2.146 | 0.555 |
| 21 | 1% Dibutylamine | 7 | 3 | 200 | ○ | 3.13 | 0.47 |
| 22 | 1% Tributylamine | 7 | 3 | 200 | ○ | 2.68 | 0.55 |
| 23 | 1% Monoethanolamine | 7 | 3 | 200 | ○ | 1.46 | 0.622 |
| 24 | 1% Triammonium citrate | 7 | 3 | 230 | ○ | 59.71 | 0.88 |
| 25 | 1% Ammonium acetate | 7 | 3 | 240 | ○ | 36.82 | 0.84 |
| 26 | 1% H₅IO₆+1%Acetic acid | 7 | 3 | 100 | ○ | 1.946 | 0.886 |
| 27 | 1% H₅IO₆+10%Acetic acid | 7 | 3 | 230 | ○ | 40.25 | 0.80 |
| 28 | 1% H₅IO₆+1% H₂SO₄ | 7 | 3 | 230 | ○ | 12.42 | 0.714 |
| 29 | 1% NaOI₄ | 7 | 3 | 200 | ○ | 1.98 | 0.794 |
| 30 | 7.4%KCI(0.1mol/I) | 7 | 3 | 300 | ○ | 2.378 | 0.7512 |
| 31 | 1%HF | 7 | 3 | 840 | × | 131.37 | 11.06 |
| 32 | 1%NH₄F | 7 | 3 | 880 | × | 39.03 | 8.07 |
| 33 | 1% H₅IO₆ +200ppmSurfactant | 7 | 3 | 300 | ○ | 25.42 | 0.92 |
| 34 | 1% H₅IO₆ +50%Acetic acid | 7 | 3 | 300 | ○ | 27.86 | 8.666 |
| 35 | 1% H₂O₂ +200ppmSurfactant | 7 | 3 | 210 | ○ | 28.34 | 0.83 |
| 36 | 1% H₂O₂ +10%Glycerin | 7 | 3 | 150 | ○ | 28.41 | 0.86 |
| 37 | 3%Citric acid | 9 | 3 | 250 | ○ | 3.556 | 1.577 |
| 38 | 30%Citric acid | 9 | 3 | 260 | ○ | 10.222 | 0.835 |
| 39 | 100ppmSulfuric acid | 9 | 3 | 160 | ○ | 10.77 | 2.222 |
| 40 | 0.1%Sulfuric acid | 9 | 3 | 530 | ○ | 49.34 | 2.222 |
| 41 | 1%Sulfuric acid | 9 | 3 | 490 | ○ | 275.6 | 4.444 |
| 42 | 20%Sulfuric acid | 9 | 3 | 490 | ○ | 10013.4 | 3.668 |
| 43 | 20%Sulfuric acid | 9 | 10 | 1200 | ○ | 131.12 | 1.5996 |
| 44 | 20%Methanesulfonic acid | 9 | 3 | 240 | ○ | 252 | 2.306 |
| 45 | 1%Phosphoric acid | 9 | 3 | 680 | ○ | 65.78 | 2.444 |
| 46 | 20%Phosphoric acid | 9 | 3 | 290 | ○ | 243.2 | 5.546 |
| 47 | 20%Polyphosphoric acid | 9 | 3 | 280 | ○ | 218.28 | 5.22 |

As is clear from the results shown in Table 1, in each of Test Examples 1 to 47, an oxidized film could be formed on a desired surface of the silicon carbide single crystal substrate in a short time under mild conditions such as room temperature. It can be said that both oxidized films formed in Test Examples 31 and 32 containing fluorine anions in the electrolyte solution were poor in etching removability.

### [Treatment (2) of SiC Substrate]

An anodization treatment of SiC substrates was performed by using a 1% H₅IO₆ electrolyte solution in the same manner as in [Treatment (1) of SiC Substrate: Formation of Oxidized Film by Anodization] described above. Thereafter, the SiC substrate on which the oxidized film had been formed was treated under the conditions shown in Table 2 to remove the oxidized films. Cross-section observation was performed by X-SEM, and a sample from which the oxidized film had been removed was evaluated as "O" (good), and a sample from which the oxidized film had not been removed was evaluated as "X" (poor). The results are shown in Table 2.

**[Table 2]**

| Conditions for oxidized film removal treatment | | | | | Oxidized film removal evaluation |
|---|---|---|---|---|---|
| Treatment method | Treatment conditions | Treatment temperature (°C) | Treatment time (min) | Device | |
| Wet etching | 5%HF | 23 | 10 | Beaker evaluation | ○ |
| | BHF (1%HF+20%NH₄F) | 23 | 10 | Beaker evaluation | ○ |
| Dry etching | CF₄/O₂=90/10sccm, RF=1200W,Bias 200W | 23 | 3 | Evaluation device for experiments | ○ |
| Ashing | CF₄/O₂=50/100sccm, RF=600W | 80 | 3 | TCA3822 (manufactured by Tokyo Ohka Kogyo) | ○ |

As is clear from the results shown in Table 2, it can be seen that each oxidized film formed on the SiC substrate by the method of the present invention could be satisfactorily removed by any of wet etching, dry etching, or ashing.

### [Evaluation of Bubble Formation]

Similarly to [Treatment (1) of SiC Substrate: Formation of Oxidized Film by Anodization] described above, a SiC wafer (having a silicon carbide semiconductor layer epitaxially grown on the first main surface, manufactured by Showa Denko) was used as an anode, an Ag/AgCl electrode was used as a reference electrode, and a Pt electrode was used as a negative electrode. The electrolyte solutions of Test Examples 4, 16, 33, 34, 35 or 36 were each placed in a beaker, and the SiC substrate was subjected to an anodization treatment at room temperature (23°C) under conditions of a voltage of 7 V and a treatment time of 3 minutes. After the anodization treatment, the presence or absence of bubble formation on each SiC substrate was visually evaluated, and a sample without bubble formation was evaluated as "O" (good), and a sample with bubble formation was evaluated as "X" (poor). The results are shown in Table 3.

**[Table 3]**

| Test Example | Electrolyte solution | Voltage application | | Foaming evaluation | Oxidized film removal evaluation |
|---|---|---|---|---|---|
| | | Voltage (V) | Treatment time (min) | | |
| 4 | 1% H₅IO₆ | 7 | 3 | × | ○ |
| 16 | 1% H₂O₂ | 7 | 3 | × | ○ |
| 33 | 1% H₅IO₆ +200ppmSurfactant | 7 | 3 | ○ | ○ |
| 34 | 1% H₅IO₆ +50%Acetic acid | 7 | 3 | ○ | ○ |
| 35 | 1% H₂O₂ +200ppmSurfactant | 7 | 3 | ○ | ○ |
| 36 | 1% H₂O₂ +10%Glycerin | 7 | 3 | ○ | ○ |

As is clear from the results shown in Table 3, bubble formation occurred in Test Examples 4 and 16 in which the electrolyte solution did not contain an antifoaming agent. On the other hand, in Test Examples 33 to 36 in which the electrolyte solution contained an antifoaming agent, bubble formation could be suppressed.

### [Evaluation by XPS Measurement]

### (Test Example 48)

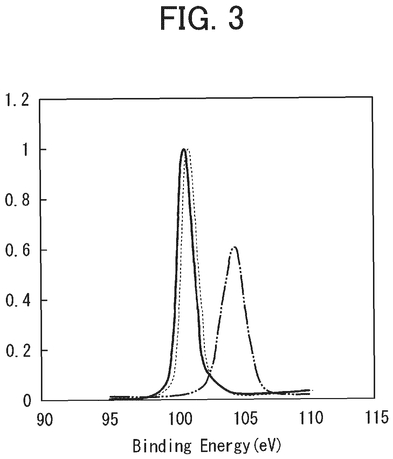

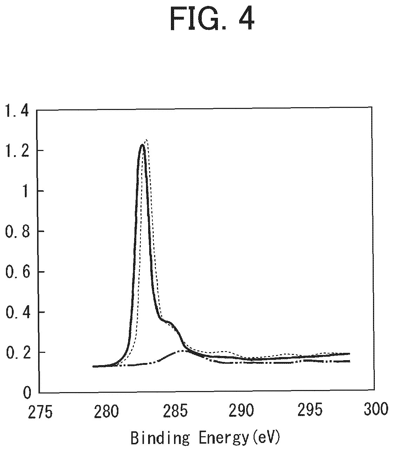

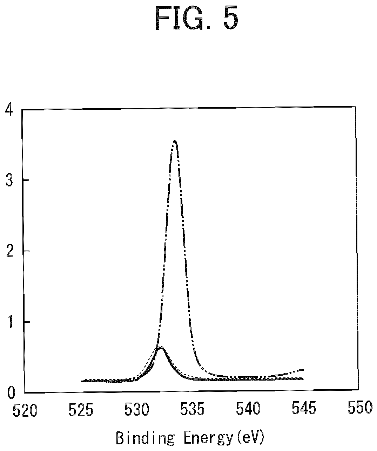

A SiC wafer as an anode and Pt as a cathode were immersed in a 1% periodic acid (H₅IO₆) solution, and a voltage of 7 V was applied at room temperature for 3 minutes. Subsequently, the SiC wafer was washed with water for 30 seconds in a beaker and dried by a N₂ blow, and then the surface of the SiC wafer was subjected to XPS measurement using K-Alpha (manufactured by Thermo Scientific). The results of qualitative analysis by the XPS measurement are shown in Table 4. XPS spectra of Si, C and O are shown in FIGs. 3 to 5.

### (Test Example 49)

A SiC wafer as an anode and Pt as a cathode were immersed in a 1% periodic acid (H₅IO₆) solution, and a voltage of 7 V was applied at room temperature for 3 minutes. Subsequently, the SiC wafer was washed with water in a beaker for 30 seconds, and then immersed in 5% HF at room temperature for 10 minutes to remove the oxidized film. After the oxidized film removal treatment, the SiC wafer was washed with water for 30 seconds in a beaker and dried by a N₂ blow, and then the surface of the SiC wafer was subjected to XPS measurement using K-Alpha (manufactured by Thermo Scientific). The results of qualitative analysis by the XPS measurement are shown in Table 4. XPS spectra of Si, C and O are shown in FIGs. 3 to 5.

**[Table 4]**

| | Si(%) | C(%) | O(%) |
|---|---|---|---|
| Ref(Untreated) | 49.2 | 49.2 | 1.6 |
| Test Example48 | 33.5 | 1.0 | 65.5 |
| Test Example49 | 49.4 | 49.4 | 1.2 |

As is clear from the results shown in Table 4 and FIGs. 3 to 5, it can be seen that an oxidized film was formed in Test Example 48. In addition, since the component ratios of Test Example 49, which had been subjected to the porous film removal treatment, were the same as Si, C, and O component ratios of an untreated SiC substrate, it can be seen that the oxidized film had been removed.

### EXPLANATION OF REFERENCE NUMERALS

1 Anode
2 Cathode
4 Electrolyte solution
5 Electrolysis bath
6 Power source
7 Power source controller
8 Seal
9 Oxidized film
100 Silicon carbide single crystal substrate treating system

## Claims

1. A method for treating a silicon carbide single crystal substrate, comprising: a step (A) of forming an oxidized film on at least one main surface of the silicon carbide single crystal substrate by anodization using the silicon carbide single crystal substrate as an anode and applying a voltage while bringing the at least one main surface of the silicon carbide single crystal substrate into contact with an electrolyte solution free of a fluorine anion.

2. The method for treating a silicon carbide single crystal substrate according to claim 1, wherein the electrolyte solution has a final current density of 0.01 mA/cm² or more, the final current density being a current density, a variation width of which is in a range of ±3 mA/cm² continuously for 60 seconds after the voltage is applied in the step (A).

3. The method for treating a silicon carbide single crystal substrate according to claim 1, further comprising a step (B) of removing the oxidized film by any of etching using at least one etchant selected from the group consisting of hydrofluoric acid and a mixture of hydrofluoric acid and ammonium fluoride, dry etching, ashing, or CMP.

4. The method for treating a silicon carbide single crystal substrate according to claim 3, wherein the dry etching or the ashing comprises etching with a gas comprising a halogen atom.

5. The method for treating a silicon carbide single crystal substrate according to claim 1, wherein the electrolyte solution comprises at least one selected from the group consisting of orthoperiodic acid, a periodate salt, iodic acid, and an iodate salt.

6. The method for treating a silicon carbide single crystal substrate according to claim 1, wherein the electrolyte solution comprises at least one selected from the group consisting of an acid free of a fluorine atom, a peracid free of a fluorine atom, and hydrogen peroxide.

7. The method for treating a silicon carbide single crystal substrate according to claim 6, wherein the electrolyte solution is at least one selected from the group consisting of a carboxylic acid free of a fluorine atom, a percarboxylic acid free of a fluorine atom, a sulfonic acid free of a fluorine atom, a phosphonic acid free of a fluorine atom, an inorganic acid free of a fluorine atom, and hydrogen peroxide.

8. The method for treating a silicon carbide single crystal substrate according to claim 7, wherein the sulfonic acid free of a fluorine atom comprises at least one selected from the group consisting of sulfuric acid and methanesulfonic acid.

9. The method for treating a silicon carbide single crystal substrate according to claim 7, wherein the phosphonic acid free of a fluorine atom comprises at least one selected from the group consisting of phosphoric acid and polyphosphoric acid.

10. The method for treating a silicon carbide single crystal substrate according to claim 1, wherein the electrolyte solution comprises an alkali free of a fluorine atom.

11. The method for treating a silicon carbide single crystal substrate according to claim 10, wherein the alkali is at least one selected from the group consisting of a quaternary ammonium hydroxide salt free of a fluorine atom, a tertiary amine free of a fluorine atom, a secondary amine free of a fluorine atom, a primary amine free of a fluorine atom, and ammonia.

12. The method for treating a silicon carbide single crystal substrate according to claim 1, wherein the electrolyte solution comprises an ammonium salt free of a fluorine atom.

13. The method for treating a silicon carbide single crystal substrate according to claim 1, wherein the electrolyte solution comprises at least one antifoaming agent selected from the group consisting of an organic solvent and a surfactant.

14. The method for treating a silicon carbide single crystal substrate according to claim 13, wherein the antifoaming agent comprises an alcohol solvent.

15. The method for treating a silicon carbide single crystal substrate according to any one of claims 1 to 12, wherein the step (A) is performed at a liquid temperature of the electrolyte solution of 300°C or less.

16. A silicon carbide single crystal substrate treating system comprising:
an anode that is a silicon carbide single crystal substrate;
a cathode opposed to the silicon carbide single crystal substrate;
an electrolyte solution interposed between the silicon carbide single crystal substrate and the cathode, being in contact with the anode and the cathode, and being free of a fluorine anion; and
a power source device connected between the anode and the cathode and causing anodization at an interface of at least one main surface of the anode by application of a voltage.

17. A replenishing liquid for replenishing the electrolyte solution for use in the method for treating a silicon carbide single crystal substrate according to claim 1, wherein the replenishing liquid has a higher electrolyte concentration than the electrolyte solution.
